# EUROPEAN PATENT SPECIFICATION

(11) **EP 1 325 946 B1**
(45) Date of publication and mention of the grant of the patent: **30.03.2005**
(21) Application number: 02258589.7
(22) Date of filing: 12.12.2002
(51) Int. Cl.: C09D 143/04, C09D 133/06, C23F 11/173

(54) **Coating composition for the protection of packaging and interconnecting boards**
Beschichtungszusammensetzung zum Schutz von Platinen und Leiterplatten
Composition de revêtement pour la protection des substrats et des interconnexions de cartes électroniques

(30) Priority: 14.12.2001 JP 2001381007
(43) Date of publication of application: 09.07.2003
(73) Proprietor: SHIN-ETSU CHEMICAL CO., LTD., Chiyoda-ku, Tokyo (JP)
(72) Inventor: Itagaki, Akinari, Shin-Etsu Chemical Co., Ltd, Usui-gun, Gunma-ken (JP); Yamaya, Masaaki, Shin-Etsu Chemical Co., Ltd, Usui-gun, Gunma-ken (JP); Yoshizawa, Masahiro, Shin-Etsu Chemical Co., Ltd, Usui-gun, Gunma-ken (JP)
(74) Representative: Stoner, Gerard Patrick

(56) References cited:
- EP-A- 0 738 768
- EP-A- 0 824 127
- EP-A- 0 841 355
- EP-A- 0 932 083
- EP-A- 1 229 092
- US-A- 5 322 714

## Description

This invention relates to the use of a (meth)acrylic resin based coating composition for the protection of packaging and interconnecting boards, endling the prevention of sulfidation of metal portions on the boards.

Packaging and interconnecting structures or boards, also known as circuit boards, having electric and electronic parts mounted thereon are used as electrical components in automobiles and aircraft. It is common practice to cover the circuit boards with coating compositions based on resins or high viscosity oils for the purposes of maintaining electrically insulating properties, and protecting the circuit boards from a harsh exterior environment such as a hot humid, wet or dusty environment.

Coating compositions which fully cover entire packaging and interconnecting boards are generally known as conformal coatings. From the standpoint of preventing electronic devices on the circuit board surface from failure caused by high temperature, mechanical stresses or other factors, the conformal coating composition must be a material which will cure at low temperature below about 100° C and induce minimal stresses upon thermal expansion or contraction during the curing step, or during environmental temperature changes after coat formation. Or, it must be an elastic material which absorbs the stresses induced by thermal expansion or contraction and does not conduct them to the electronic devices. From the environmental hygienic standpoint, coating compositions free of solvents, that is, solventless type are desired.

To meet these requirements, there have already been developed silicone coating compositions of the addition reaction type using platinum catalysts or UV curing reaction type, which eliminate a need to dilute with solvents. In the case of addition reaction type silicone compositions, however, certain materials of parts mounted on the circuit board surface can poison the platinum catalyst, inhibiting the silicone compositions from curing. They are useful only in limited applications. Also, silicone compositions of the UV curing reaction type have the problem that dark portions which are shielded from UV exposure do not cure, and are thus inadequate as coating compositions for covering circuit boards having parts of complex shape mounted thereon.

Also, room temperature curable silicone rubber compositions of the condensation reaction type are currently available on the market and have a viscosity in excess of 1,000 mPa·s at 25°C. When these coating compositions are applied to circuit boards, conventional coating techniques such as dip coating, flow coating, brush coating and spray coating cannot be employed on account of such a high viscosity.

To solve the above-mentioned problems, JP-A 7-173435 (EP-A-738678) proposes a silicone coating composition. It is a room temperature curable, solventless, silicone coating composition comprising an organopolysiloxane end-blocked with hydroxyl groups, an organoxysilane compound or partial hydrolyzate thereof, and a curing catalyst and having a viscosity of 20 to 1,000 mPa·s at 25°C. Because of a low viscosity, this composition can be easily applied by various coating techniques. Upon contact with air-borne moisture, the composition quickly cures at room temperature without releasing toxic or corrosive gases. The cured composition possesses rubbery elasticity and thus absorbs stresses, causing no damage to those parts mounted on the circuit board surface. In addition, the composition is firmly adherent to circuit boards and of the solventless type. Owing to these advantages, the composition is suited for conformal coating purposes and currently used in a variety of applications.

Most circuit boards use copper wiring (as in copper clad laminates) and gold wiring from the past. Recently, manufacture of circuit boards using silver wiring is increasing because of a lower contact resistance than copper conductors, ease of working, and a lower price than gold. The silver wiring is expected to become a main stream of wiring technology in the automotive application, as evidenced by the employment of silver wiring in air flow sensors. With regard to circuit boards employing the silver wiring technology, however, troubles in electric circuits as a result of corrosion of silver conductors have been reported. An analysis revealed that these troubles arose from corrosion by sulfidation. Presumably, in a situation where a rubber article is located within or in proximity to a module and the service environment reaches relatively high temperature, sulfur contained in the rubber article as the vulcanizing agent will volatilize and come in contact with silver lines to incur a corrosion phenomenon. It is confirmed that in fact, sulfur existing in quantities of ppm order can cause corrosion of silver.

Particularly in the automotive application, the service environment in proximity to the engine reaches higher temperatures, and many rubber articles such as rubber dampers are used. It is impossible to eliminate the sulfur source because it is very difficult in a substantial sense to reduce or control the content of sulfur components in rubber. As a result of size reduction of air flow sensors and other devices, such modules are sometimes directly mounted on the engine. Additionally, since not only rubber articles but also exhaust gases are sulfur sources, there is an increasing propensity that corrosion with sulfur is problematic.

Under the above-mentioned circumstances, conformal coating compositions which have been used for the purpose of forming moisture-proof barriers are now required to prevent contact with sulfur for inhibiting sulfidation of metals as well. However, when coatings in the form of room temperature curable silicone rubber compositions are applied to circuit boards, it is found that the progress of sulfidation becomes faster than with bare boards without any coating: the reason is not well understood. Conformal coating compositions which are effective for preventing sulfidation of metals have not been noted. There is a desire for a way of solving this problem, as well as a more general desire for new and useful methods of making conformal coatings.

EP-A-1229092, filed before but published after the priority date of the present patent, describes polymer compositions for making hard, smooth, strong coatings. Mentioned uses are particularly as release films for the production of ceramic condensers, but also as general release layers and coatings; PCB's are mentioned among other possible substrates. The compositions are based on a polymer, which may be a vinyl e.g. (meth)acrylic polymer or copolymer, carrying hydroxyl and/or hydrolytic group on a silicon atom.

An object of the invention is to provide a coating method suitable for the protection of packaging and interconnecting boards, which can be easily and reliably applied to packaging and interconnecting boards using conventional techniques such as dip coating, flow coating, brush coating and spray coating. After coating, it is desired to cure with air-borne moisture to form a uniform coat that maintains good electrically insulating properties and protects underlying metal portions from corrosion, especially by sulfur compounds (i.e., sulfidation). A protected packaging and interconnecting board made by the method is another object.

We have found that when a coating composition obtained by dissolving in a volatile solvent a (meth)acrylic resin containing hydrolyzable silyl and/or silanol groups, having a silicon atom content of 0.1 to 5% by weight and a weight average molecular weight of 1,500 to 30,000, and containing at least 50 mol% based on the monomeric components of methyl methacrylate, and optionally adding an organometallic condensation catalyst thereto is applied to a packaging and interconnecting board, dried and cured with air-borne moisture, the resulting coat is effective even for preventing sulfidation of metals. The coating composition can be easily and reliably applied to packaging and interconnecting boards by conventional techniques such as dip coating, flow coating, brush coating and spray coating. Since the coating composition cures at low temperatures e.g. below about 100° C and induces low stresses upon thermal expansion or contraction during the curing step or by environmental temperature changes after coat formation, electronic devices on the circuit board surface are protected from failure by high temperature, mechanical stresses or other factors. In addition, the coating composition is conformal to and firmly adherent to circuit boards. Therefore, the coating composition can be advantageously used in the conformal coating application and especially, as a coating material for covering silver-wired circuit boards.

More particularly, cured films of prior art room temperature curable silicone coating compositions have difficulty in preventing penetration of sulfur, and no improvements in such effect were achieved by increasing the crosslinking density or introducing various substituent groups. By contrast, it was found that among organic resin base coating compositions, films of high molecular weight acrylic resins can uniquely prevent sulfidation of metals. However, when high molecular weight acrylic resins are dissolved in volatile solvents, the resulting solutions have a very high viscosity. The solutions must be diluted to very low concentrations of 10 to 20% by weight solids before they can be applied to circuit boards. This necessitates the use of large quantities of volatile solvents and is impractical. In order that solutions having high concentrations of 50% by weight solids or greater have viscosities low enough to apply to substrates by such techniques as dip coating, flow coating, brush coating and spray coating, the weight average molecular weight of acrylic resins must be 30,000 or less, preferably 10,000 or less. Such low molecular weight acrylic resins, however, are unable to prevent penetration of sulfur, failing to prevent metal sulfidation.

Studying the composition of (meth)acrylic resins, we found that those (meth)acrylic resins containing a greater quantity of methyl methacrylate among monomeric components are more effective for preventing metal sulfidation. Our continued study revealed that by introducing hydrolysable silyl and/or silanol groups into the (meth)acrylic resin structure, even a low-molecular weight resin having a weight average molecular weight of up to 30,000 cures with air-borne moisture by virtue of the silyl or silanol groups serving as crosslinking sites during film formation and thus converts to a high-molecular weight resin, resulting in a coat having an ability to prevent metal sulfidation. In addition, when the protective coating composition is dissolved in a volatile solvent, even a thick solution having a solids concentration of 50 wt% or more has a viscosity sufficiently low to enable application to various substrates.

One aspect of the invention is a method of making a packaging and interconnecting board having electrical and electronic parts mounted thereon, and coated to protect metal portions on the board, comprising:
applying a coating composition to the board;
drying the applied composition to form a coat, and
exposing the coat to air-borne moisture for curing the coat;
characterised in that the coating composition primarily comprises (meth)acrylic resin which contains hydrolysable silyl and/or silanol groups, has a silicon atom content of from 0.1 to 5% by weight and a weight average molecular weight of from 1,500 to 30,000, and in which at least 50 mol% of monomer residues are of methyl methacrylate.

We find that such a coating is capable of preventing sulfidation of metal portions when applied and laminated to the packaging and interconnecting board.

Another aspect is a packaging and interconnecting board made by the method.

### FURTHER EXPLANATIONS; OPTIONS AND PREFERENCES

The coating composition used herein for the protection of packaging and interconnecting boards contains as a main component a (meth)acrylic resin which should have a weight average molecular weight (Mw) in the range of 1,500 to 30,000. The reason is that a (meth)acrylic resin with a Mw of less than 1,500, even when hydrolyzable silyl and/or silanol groups are introduced therein, does not convert to a sufficiently high molecular weight resin during film formation because the original molecular weight is too low, with the resulting film lacking metal sulfidation-preventing effect. When a (meth)acrylic resin with a Mw of more than 30,000 is dissolved in a volatile solvent, the solution has too high a viscosity to apply uniformly to a substrate of complex shape, suggesting that the solution must have a low solids concentration of less than 50% by weight. The preferred weight average molecular weight is from 2,000 to 10,000.

The (meth)acrylic resin should contain hydrolysable silyl groups and/or hydrolysable silanol groups on side chains and/or ends of the (meth)acrylic polymer molecular chain. The inclusion of hydrolysable silyl and/or silanol groups ensures that even a low molecular weight polymer, having a weight average molecular weight of up to 30,000 cures with air-borne moisture by virtue of the silyl or silanol groups serving as crosslinking sites during film formation and thus converts to a high-molecular weight resin, resulting in a coat having good metal sulfidation-preventing effect. The quantity of silyl or silanol groups which can be introduced is correlated to the content of silicon atoms. If the silicon atom content is less than 0.1% by weight, only a less number of crosslinking sites are available so that no substantial conversion to a high molecular weight resin takes place during film formation, failing to provide the metal sulfidation-preventing effect. If the silicon atom content is more than 5% by weight, there arise problems that no further enhancement of metal sulfidation-preventing effect is achieved, that the use of a larger amount of a silane compound which is more expensive than (meth)acrylic monomers, among monomeric components used for the preparation of the resin, leads to an increased cost, and that a film having a high hardness forms because of too many crosslinking sites so that it is likely to crack during film formation and during operation of circuit boards, failing to serve for the purpose of protective coatings. Thus, silicon atom content in the (meth)acrylic resin is from 0.1%, preferably from 0.2% by weight. The preferred upper limit is 5 wt%, more preferably up to 3 wt%.

Illustratively, the hydrolyzable silyl and silanol groups are represented by the following general formula (1).

-SiXₐR¹ ₃₋ₐ (1)

Herein X is a hydroxyl group or a hydrolyzable group. Suitable hydrolyzable groups include halogen atoms such as chlorine and bromine, alkoxy groups such as methoxy, ethoxy and isopropoxy, acyloxy groups such as acetoxy, oxime groups such as methyl ethyl ketoxime, amide groups such as N-ethylacetamide, alkenoxy groups such as isopropenoxy, and amino groups such as dimethylamino and diethylamino. R¹ is hydrogen or a monovalent hydrocarbon group of 1 to 10 carbon atoms selected from, for example, alkyl groups such as methyl, ethyl, propyl, butyl, hexyl and decyl, cycloalkyl groups such as cyclohexyl, and aryl groups such as phenyl and tolyl. The subscript "a" is an integer of 1 to 3.

The (meth)acrylic resins containing hydrolyzable silyl and/or silanol groups can be prepared, for example, by the following process (A) or (B).

Process (A) starts with an unsaturated (meth)acrylic polymer having carbon-to-carbon double bonds and performs addition reaction of a hydrosilane compound of the following formula (2) to the carbon-to-carbon double bonds in the polymer.

HSiXₐR¹ ₃₋ₐ (2)

In formula (2), X, R¹ and "a" are as defined above for formula (1). Examples of such hydrosilane compounds include halosilanes such as trichlorosilane, methyldichlorosilane, phenyldichlorosilane and dimethylchlorosilane; alkoxysilanes such as trimethoxysilane, triethoxysilane, methyldimethoxysilane, methyldiethoxysilane, phenyldimethoxysilane, and dimethylmethoxysilane; acyloxysilanes such as triacetoxysilane, methyldiacetoxysilane and phenyldiacetoxysilane; oximesilanes such as trismethylethylketoximesilane; and alkenoxysilanes such as triisopropenoxysilane. These hydrosilane compounds may be used alone or in admixture of two or more.

The unsaturated (meth)acrylic polymer used in process (A) can be prepared by any well-known method. For example, by copolymerizing a (meth)acrylic monomer having a functional group such as carboxyl, hydroxyl or epoxy with a (meth)acrylic monomer free of a functional group, such as methyl methacrylate, then reacting an unsaturated compound having a functional group capable of reacting with the above-mentioned functional group and a carbon-to-carbon double bond with the above-mentioned functional groups in the copolymer, an unsaturated (meth)acrylic polymer having carbon-to-carbon double bonds on side chains of the polymeric molecular chain can be prepared.

Process (B) is by copolymerizing a (meth)acrylic monomer with an unsaturated silane compound of the following general formula (3).

R²SiXₐR¹ ₃₋ₐ (3)

In formula (3), X, R¹ and "a" are as defined above for formula (1), and R² is an organic group having a polymerizable double bond such as vinyl, acryloxymethyl, γ-acryloxypropyl, methacryloxymethyl or γ-methacryloxypropyl. Examples of such unsaturated silane compounds include vinylsilanes such as vinyltrichlorosilane, vinyltrimethoxysilane, vinyltriethoxysilane, vinyltriisopropoxysilane, vinyltriacetoxysilane, vinyltrismethylethylketoximesilane, vinyltriisopropenoxysilane, vinylmethyldimethoxysilane and vinyldimethylmethoxysilane; acrylsilanes such as acryloxymethyltrichlorosilane, acryloxymethyltrimethoxysilane, acryloxymethyltriethoxysilane, acryloxymethylmethyldimethoxysilane, acryloxymethyldimethylmethoxysilane, γ-acryloxypropyltrichlorosilane, γ-acryloxypropyltrimethoxysilane, γ-acryloxypropyltriethoxysilane, γ-acryloxypropylmethyldimethoxysilane, γ-acryloxypropylmethyldiethoxysilane, and γ-acryloxypropyldimethylmethoxysilane; methacrylsilanes such as methacryloxymethyltrichlorosilane, methacryloxymethyltrimethoxysilane, methacryloxymethyltriethoxysilane, methacryloxymethylmethyldimethoxysilane, methacryloxymethyldimethylmethoxysilane, γ-methacryloxypropyltrichlorosilane, γ-methacryloxypropyltrimethoxysilane, γ-methacryloxypropyltriethoxysilane, γ-methacryloxypropylmethyldimethoxysilane, γ-methacryloxypropylmethyldiethoxysilane, and γ-methacryloxypropyldimethylmethoxysilane; and styrylsilanes such as styryltrimethoxysilane, styryltriethoxysilane, styrylmethyldimethoxysilane, N-vinylbenzyl-γ-aminopropyltrimethoxysilane, and N-vinylbenzyl-γ-aminopropylmethyldimethoxysilane. These unsaturated silane compounds may be used alone or in admixture of two or more.

Examples of (meth)acrylic monomers used in the preparation of (meth)acrylic resins containing hydrolyzable silyl and/or silanol groups by process (A) or (B) or the like, include acrylic acid, methacrylic acid, methyl acrylate, methyl methacrylate, ethyl acrylate, ethyl methacrylate, propyl acrylate, propyl methacrylate, n-butyl acrylate, n-butyl methacrylate, isobutyl acrylate, isobutyl methacrylate, amyl acrylate, amyl methacrylate, isoamyl acrylate, isoamyl methacrylate, hexyl acrylate, hexyl methacrylate, cyclohexyl acrylate, cyclohexyl methacrylate, n-octyl acrylate, n-octyl methacrylate, 2-ethylhexyl acrylate, 2-ethylhexyl methacrylate, isobornyl acrylate, isobornyl methacrylate, 2-hydroxyethyl acrylate, 2-hydroxyethyl methacrylate, 2-hydroxypropyl acrylate, 2-hydroxypropyl methacrylate, 3-hydroxypropyl acrylate, 3-hydroxypropyl methacrylate, acrylamide, methacrylamide, N-methylolacrylamide, N-methylolmethacrylamide, glycidyl acrylate, glycidyl methacrylate, trifluoropropyl acrylate, trifluoropropyl methacrylate, etc.

In the (meth)acrylic resin used herein, at least 50 mol% of the monomeric components must be methyl methacrylate. Those (meth)acrylic resins containing at least 50 mol% based on the (meth)acrylic monomeric components of methyl methacrylate are more effective for preventing metal sulfidation. It is acceptable to partially use other copolymerizable vinyl monomers such as styrene, α-methylstyrene, maleic acid, butadiene or acrylonitrile as long as they do not compromise desired properties of the protective coating composition.

In the manufacture of the (meth)acrylic resin containing hydrolyzable silyl and/or silanol groups according to the invention, it is preferred, partially because of a simple procedure, to prepare the resin by copolymerizing an unsaturated silane compound having a polymerizable double bond and a hydrolyzable silyl group with methyl methacrylate and another (meth)acrylic monomer in the presence of a radical polymerization initiator such as azobisisobutyronitrile according to the above-mentioned process (B). The polymerization techniques used herein include a technique of adding monomers at a time, followed by polymerization, a technique of polymerizing portions of monomers and adding the remaining portions continuously or intermittently, a technique of continuously adding monomers from the initial stage of polymerization, and combinations thereof. The preferred polymerization technique is solution polymerization. The solvent which can be used for solution polymerization may be selected from a variety of solvents which are described below as the volatile solvent in which the (meth)acrylic resin is to be dissolved, for example, alcohol, ketone, ether and ester solvents. From the standpoints of manufacturing process and cost savings, it is preferred that the reaction solvent used for solution polymerization be the same as the volatile solvent which is used in helping the protective coating composition be applied to substrates. The proportion of the unsaturated silane compound and the monomers used in copolymerization is preferably such that 0.5 to 20 mol% of the unsaturated silane compound, 40 to 99.5 mol% of methyl methacrylate, and 0 to 49 mol% of another (meth)acrylic monomer are copolymerized. [Note : below 50 mol% MMA is outside the invention] More preferably, 0.5 to 20 mol% of the unsaturated silane compound, 50 to 99.5 mol% of methyl methacrylate, and 0 to 40 mol% of butyl acrylate are copolymerized.

When the coating compositions is applied to a substrate having metal portions on its surface, namely a packaging and interconnecting board for protection purposes, a solution of the (meth)acrylic resin containing hydrolyzable silyl and/or silanol groups in a volatile solvent is used. The volatile solvent used herein is not critical as long as the (meth)acrylic resin is uniformly dissolvable therein. Illustrative, non-limiting, examples include aliphatic hydrocarbon solvents such as n-pentane, n-hexane, cyclohexane, n-heptane, methylcyclohexane, n-octane, and isooctane; aromatic hydrocarbon solvents such as benzene, toluene, xylene, ethylbenzene, trimethylbenzene, methylethylbenzene, propylbenzene, and diethylbenzene; alcohol solvents such as methanol, ethanol, n-propanol, isopropanol, n-butanol, isobutanol, 2-butanol, t-butanol, 3-methoxybutanol, n-hexanol, 2-hexanol, n-octanol, 2-ethylhexanol, n-decanol, cyclohexanol, phenol, benzyl alcohol, diacetone alcohol, and cresol; polyhydric alcohols such as ethylene glycol, propylene glycol, butylene glycol, hexane diol, diethylene glycol, dipropylene glycol, triethylene glycol, and glycerin; ketone solvents such as acetone, methyl ethyl ketone, methyl n-propyl ketone, methyl n-butyl ketone, diethyl ketone, methyl isobutyl ketone, ethyl n-butyl ketone, methyl n-hexyl ketone, diisobutyl ketone, cyclohexanone, methylcyclohexanone, pentanedione, and acetophenone; ether solvents such as ethyl ether, isopropyl ether, n-butyl ether, n-hexyl ether, 2-ethylhexyl ether, propylene oxide, dioxane, ethylene glycol monomethyl ether, ethylene glycol monoethyl ether, ethylene glycol diethyl ether, ethylene glycol monobutyl ether, ethylene glycol dibutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, and tetrahydrofuran; and ester solvents such as methyl acetate, ethyl acetate, propyl acetate, butyl acetate, methyl acetoacetate, ethyl acetoacetate, ethyl propionate, butyl propionate, methyl lactate, ethyl lactate, butyl lactate, ethylene glycol monomethyl ether acetate, ethylene glycol monoethyl ether acetate, ethylene glycol monobutyl ether acetate, diethylene glycol monomethyl ether acetate, propylene glycol monomethyl ether acetate, propylene glycol monoethyl ether acetate, propylene glycol monopropyl ether acetate, propylene glycol monobutyl ether acetate, and dipropylene glycol monomethyl ether acetate. These volatile solvents may be used alone or in admixture of two or more. From the standpoints of lowering the viscosity of a coating solution and reducing the drying time, it is preferred to use a volatile solvent having a boiling point of 150°C or lower, more preferably toluene, acetone, methyl ethyl ketone, methyl isobutyl ketone and ethyl acetate, alone or in admixture of any. The protective coating composition should preferably contain 1 to 50% by weight of the volatile solvent when it is applied to substrates.

Such coatings appear able to prevent metal sulfidation by the mechanism that the (meth)acrylic resin having hydrolyzable silyl and/or silanol groups introduced therein forms a crosslinked structure by way of hydrolytic condensation of the hydrolyzable silyl and/or silanol groups upon contact with air-borne moisture. Accordingly, an organometallic condensation catalyst is preferably added to the protective coating composition of the invention for promoting hydrolysis and condensation reactions of silyl groups. Suitable organometallic condensation catalysts include organometallic compounds and partial hydrolyzates thereof. Illustrative examples of organometallic compounds include organic zirconium compounds such as tetra-n-butoxyzirconium, zirconium tri-n-butoxy-ethylacetoacetate, zirconium di-n-butoxy-bis(ethylacetoacetate), zirconium n-butoxy-tris(ethylacetoacetate), zirconium tetrakis(n-propylacetoacetate), zirconium tetrakis(acetylacetoacetate), and zirconium tetrakis(ethylacetoacetate); organic titanium compounds such as tetraisopropoxytitanium, tetra-n-butoxytitanium, titanium diisopropoxy-bis(ethylacetoacetate), titanium diisopropoxy-bis(acetylacetate) and titanium diisopropoxy-bis(acetylacetone); organic aluminum compounds such as triisopropoxyaluminum, tri-n-butoxyaluminum, aluminum diisopropoxy-ethylacetoacetate, aluminum diisopropoxy-acetylacetonate, aluminum di-n-butoxy-ethylacetoacetate, aluminum isopropoxy-bis(ethylacetoacetate), aluminum isopropoxy-bis(acetylacetonate), aluminum tris(ethylacetoacetate), aluminum tris(acetylacetonate), and aluminum monoacetylacetonato-bis(ethylacetoacetate); and organic tin compounds such as dibutyltin diacetate, dibutyltin dioctate, dibutyltin dilaurate, dibutyltin bis(methylmaleate), dibutyltin bis(butylmaleate), dioctyltin diacetate, dioctyltin dioctate, dioctyltin dilaurate, dioctyltin bis(methylmaleate), dioctyltin bis(butylmaleate) and dioctyltin bis(octylmaleate). These organometallic condensation catalysts may be used alone or in admixture of two or more. When the protective coating composition is applied to substrates, the content of the organometallic condensation catalyst in the composition should preferably be 0.01 to 10% by weight, more preferably 0.5 to 5% by weight.

If necessary, various additives such as silicone oil, fillers, adhesive aids, pigments, dyes, stability modifiers, antidegradants, antioxidants, antistatic agents, flame retardants, and heat transfer modifiers may be added to the protective coating composition insofar as they do not compromise the objects of the invention.

When the protective coating composition is to be applied to a substrate having metal portions on its surface, predetermined amounts of the (meth)acrylic resin having hydrolyzable silyl and/or silanol groups, the volatile solvent and the organometallic condensation catalyst may be mixed to form a homogeneous solution. The mixing technique is not critical. Preferably mixing is carried out in a dry air or nitrogen atmosphere in order to prohibit hydrolyzable silyl and/or silanol groups from undergoing hydrolysis and condensation reactions during the mixing step.

Several problems may arise if the protective coating solution has a viscosity in excess of 1,000 mm²/s at 25°C. In the event of a dip coating process of dipping a substrate in the protective coating solution and then pulling the substrate out of the solution, a so-called "tailing phenomenon" is likely to occur since dripping of the solution from the substrate does not stop instantaneously, and the coating build-up becomes thicker. The tailing phenomenon entails a loss of the solution and causes undesired staining in the subsequent step. In the event of a flow coating process, since the high viscosity solution flows slowly, it is difficult to selectively form a cured coat only on desired portions, and at the worst, masking becomes necessary. In order to uniformly apply the coating solution to a substrate of complex shape such as a circuit board without waste, the protective coating solution should preferably be adjusted to a viscosity of up to 1,000 mm²/s at 25° C, more preferably 40 to 500 mm²/s at 25° C.

The protective coating composition thus obtained is applied to various substrates by any desired processes including dip coating in a nitrogen atmosphere, flow coating by means of an automatic dispenser, spraying and brush coating. The coating build-up is usually 20 to 300 µm. Drying after application allows the volatile solvent to evaporate off, leaving a surface tack-free coat, which then crosslinks to form a cured coat upon contact with air-borne moisture. The drying and curing steps may be performed at room temperature and/or elevated temperature. When heated, the elevated temperature is preferably in the range of 30 to 100°C, especially 30 to 60°C because too high temperatures can cause bulging by rapid evaporation of the volatile solvent, deformation of the coat by heat softening, cracks by rapid shrinkage strain or the like. From the environmental standpoint, the drying line is desirably constructed as a closed system capable of recovering the evaporated volatile solvent without discharging to the ambient. After application and drying, the coated substrate may be aged for a certain time in a humid atmosphere having a relative humidity of at least 50% for promoting crosslinking reaction of hydrolyzable silyl and/or silanol groups whereby a densified coat is obtained in good time.

The substrate to which the protective coating composition of the invention is applicable is not critical as long as it has metal portions on its surface. The composition is applicable to a wide variety of substrates including substrates based on organic resins, substrates of composite materials reinforced with glass fibers or mica, glass articles and ceramic articles, preferably to substrates having silver-containing metal portions, more particularly circuit boards having silver wiring. When directly applied to various substrates, the coating composition can form cured coats that firmly bond to the substrates. If desired, any of well-known primers may be applied beforehand.

### EXAMPLE

Examples of the invention are given below by way of illustration and not by way of limitation. The viscosity is a measurement at 25°C, and the weight average molecular weight is determined from a measurement by gel permeation chromatography (GPC) using tetrahydrofuran as a solvent, by calculating on the calibration line obtained from a polystyrene standard sample.

### Preparation Example 1

A 1-liter flask equipped with a stirrer, a condenser, a thermometer and a pair of dropping funnels was charged with 50 g of methyl isobutyl ketone and with stirring, heated at 80°C. A mixture of 295 g (2.95 mol) of methyl methacrylate, 42 g (0.33 mol) of n-butyl acrylate and 90 g (0.36 mol) of γ-methacryloxypropyltrimethoxysilane was fed to one dropping funnel, and a solution of 73 g of 2,2'-azobis(2-methylbutyronitrile) in 75 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution A of a trimethoxysilyl group-containing (meth)acrylic copolymer with a weight average molecular weight of 2,400 and a silicon atom content of 2.0 wt%, having a solids concentration of 80%.

### Preparation Example 2

A 1-liter flask equipped with a stirrer, a condenser, a thermometer and a pair of dropping funnels was charged with 90 g of methyl isobutyl ketone and with stirring, heated at 80°C. A mixture of 318 g (3.18 mol) of methyl methacrylate, 45 g (0.35 mol) of n-butyl acrylate and 98 g (0.40 mol) of γ-methacryloxypropyltrimethoxysilane was fed to one dropping funnel, and a solution of 39 g of 2,2'-azobis(2-methylbutyronitrile) in 124 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution B of a trimethoxysilyl group-containing (meth)acrylic copolymer with a weight average molecular weight of 5,200 and a silicon atom content of 2.2 wt%, having a solids concentration of 70%.

### Preparation Example 3

A 1-liter flask equipped with a stirrer, a condenser, a thermometer and a pair of dropping funnels was charged with 110 g of methyl isobutyl ketone and with stirring, heated at 80°C. A mixture of 330 g (3.30 mol) of methyl methacrylate, 47 g (0.37 mol) of n-butyl acrylate and 101 g (0.41 mol) of γ-methacryloxypropyltrimethoxysilane was fed to one dropping funnel, and a solution of 22 g of 2,2'-azobis(2-methylbutyronitrile) in 159 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution C of a trimethoxysilyl group-containing (meth)acrylic copolymer with a weight average molecular weight of 9,100 and a silicon atom content of 2.3 wt%, having a solids concentration of 65%.

### Preparation Example 4

A 1-liter flask equipped with a stirrer, a condenser, a thermometer and a pair of dropping funnels was charged with 160 g of methyl isobutyl ketone and with stirring, heated at 80°C. A mixture of 339 g (3.39 mol) of methyl methacrylate, 48 g (0.38 mol) of n-butyl acrylate and 104 g (0.42 mol) of γ-methacryloxypropyltrimethoxysilane was fed to one dropping funnel, and a solution of 9 g of 2,2'-azobis(2-methylbutyronitrile) in 173 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution D of a trimethoxysilyl group-containing (meth)acrylic copolymer with a weight average molecular weight of 20,800 and a silicon atom content of 2.3 wt%, having a solids concentration of 60%.

### Preparation Example 5

A 1-liter flask equipped with a stirrer, a condenser, a thermometer and a pair of dropping funnels was charged with 90 g of methyl isobutyl ketone and with stirring, heated at 80°C. A mixture of 393 g (3.93 mol) of methyl methacrylate, 57 g (0.45 mol) of n-butyl acrylate and 11 g (0.044 mol) of γ-methacryloxypropyltrimethoxysilane was fed to one dropping funnel, and a solution of 39 g of 2,2'-azobis(2-methylbutyronitrile) in 124 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution E of a trimethoxysilyl group-containing (meth)acrylic copolymer with a weight average molecular weight of 5,600 and a silicon atom content of 0.25 wt%, having a solids concentration of 70%.

### Preparation Example 6

A 1-liter flask equipped with a stirrer, a condenser, a thermometer and a pair of dropping funnels was charged with 90 g of methyl isobutyl ketone and with stirring, heated at 80°C. A mixture of 355 g (3.55 mol) of methyl methacrylate, 54 g (0.42 mol) of n-butyl acrylate and 52 g (0.21 mol) of γ-methacryloxypropyltrimethoxysilane was fed to one dropping funnel, and a solution of 39 g of 2,2'-azobis(2-methylbutyronitrile) in 124 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution F of a trimethoxysilyl group-containing (meth)acrylic copolymer with a weight average molecular weight of 5,000 and a silicon atom content of 1.2 wt%, having a solids concentration of 70%.

### Preparation Example 7

A 1-liter flask equipped with a stirrer, a condenser, a thermometer and a pair of dropping funnels was charged with 90 g of methyl isobutyl ketone and with stirring, heated at 80°C. A mixture of 344 g (3.44 mol) of methyl methacrylate, 48 g (0.38 mol) of n-butyl acrylate and 72 g (0.33 mol) of γ-acryloxypropylmethyldimethoxysilane was fed to one dropping funnel, and a solution of 36 g of 2,2'-azobis(2-methylbutyronitrile) in 124 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution G of a dimethoxysilyl group-containing (meth)acrylic copolymer with a weight average molecular weight of 5,200 and a silicon atom content of 1.9 wt%, having a solids concentration of 70%.

### Preparation Example 8

A 1-liter flask equipped with a stirrer, a condenser, a thermometer and a pair of dropping funnels was charged with 90 g of methyl isobutyl ketone and with stirring, heated at 80° C. A mixture of 278 g (2.78 mol) of methyl methacrylate, 39 g (0.30 mol) of n-butyl acrylate and 147 g (0.67 mol) of γ-acryloxypropylmethyldimethoxysilane was fed to one dropping funnel, and a solution of 36 g of 2,2'-azobis(2-methylbutyronitrile) in 124 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80° C, cooling and filtration, yielding a solution H of a dimethoxysilyl group-containing (meth)acrylic copolymer with a weight average molecular weight of 4,900 and a silicon atom content of 3.8 wt%, having a solids concentration of 70%.

### Preparation Example 9

A 1-liter flask equipped with a stirrer, a condenser, a thermometer and a pair of dropping funnels was charged with 90 g of methyl isobutyl ketone and with stirring, heated at 80° C. A mixture of 361 g (3.61 mol) of methyl methacrylate and 100 g (0.40 mol) of γ-methacryloxypropyltrimethoxysilane was fed to one dropping funnel, and a solution of 39 g of 2,2'-azobis(2-methylbutyronitrile) in 124 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution I of a trimethoxysilyl group-containing (meth)acrylic copolymer with a weight average molecular weight of 5,000 and a silicon atom content of 2.3 wt%, having a solids concentration of 70%.

### Preparation Example 10

A 1-liter flask equipped with a stirrer, a condenser, a thermometer and a pair of dropping funnels was charged with 110 g of methyl isobutyl ketone and with stirring, heated at 80° C. A mixture of 207 g (2.07 mol) of methyl methacrylate, 177 g (1.38 mol) of n-butyl acrylate and 95 g (0.38 mol) of γ-methacryloxypropyltrimethoxysilane was fed to one dropping funnel, and a solution of 21 g of 2,2'-azobis(2-methylbutyronitrile) in 159 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution J of a trimethoxysilyl group-containing (meth)acrylic copolymer with a weight average molecular weight of 9,300 and a silicon atom content of 2.2 wt%, having a solids concentration of 65%.

### Preparation Example 11

A 1-liter flask equipped with a stirrer, a condenser, a thermometer and a pair of dropping funnels was charged with 90 g of methyl isobutyl ketone and with stirring, heated at 80° C. A mixture of 277 g (2.77 mol) of methyl methacrylate, 44 g (0.34 mol) of n-butyl acrylate, 45 g (0.35 mol) of 2-hydroxyethyl methacrylate, and 95 g (0.38 mol) of γ-methacryloxypropyltrimethoxysilane was fed to one dropping funnel, and a solution of 39 g of 2,2'-azobis(2-methylbutyronitrile) in 124 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution K of a trimethoxysilyl group-containing (meth)acrylic copolymer with a weight average molecular weight of 5,100 and a silicon atom content of 2.2 wt%, having a solids concentration of 70%.

### Preparation Example 12

A 1-liter flask equipped with a stirrer, a condenser, a thermometer and a pair of dropping funnels was charged with 80 g of methyl isobutyl ketone and with stirring, heated at 80° C. A mixture of 223 g (2.23 mol) of methyl methacrylate and 138 g (0.56 mol) of γ-methacryloxypropyltrimethoxysilane was fed to one dropping funnel, and a solution of 139 g of 2,2'-azobis(2-methylbutyronitrile) in 134 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80° C, cooling and filtration, yielding a solution L of a trimethoxysilyl group-containing (meth)acrylic copolymer with a weight average molecular weight of 1,200 and a silicon atom content of 3.1 wt%, having a solids concentration of 70%.

### Preparation Example 13

A 1-liter flask equipped with a stirrer, a condenser, a thermometer and a pair of dropping funnels was charged with 160 g of methyl isobutyl ketone and with stirring, heated at 80° C. A mixture of 267 g (2.67 mol) of methyl methacrylate, 85 g (0.66 mol) of n-butyl acrylate and 44 g (0.18 mol) of γ-methacryloxypropyltrimethoxysilane was fed to one dropping funnel, and a solution of 4 g of 2,2'-azobis(2-methylbutyronitrile) in 240 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution M of a trimethoxysilyl group-containing (meth)acrylic copolymer with a weight average molecular weight of 34,000 and a silicon atom content of 1.2 wt%, having a solids concentration of 50%.

### Preparation Example 14

A 1-liter flask equipped with a stirrer, a condenser, a thermometer and a pair of dropping funnels was charged with 160 g of methyl isobutyl ketone and with stirring, heated at 80° C. A mixture of 428 g (4.28 mol) of methyl methacrylate, 60 g (0.47 mol) of n-butyl acrylate and 2.4 g (0.01 mol) of γ-methacryloxypropyltrimethoxysilane was fed to one dropping funnel, and a solution of 9.6 g of 2,2'-azobis(2-methylbutyronitrile) in 173 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80° C, cooling and filtration, yielding a solution N of a trimethoxysilyl group-containing (meth)acrylic copolymer with a weight average molecular weight of 19,500 and a silicon atom content of 0.05 wt%, having a solids concentration of 60%.

### Preparation Example 15

A 1-liter flask equipped with a stirrer, a condenser, a thermometer and a pair of dropping funnels was charged with 90 g of methyl isobutyl ketone and with stirring, heated at 80° C. A mixture of 170 g (1.70 mol) of methyl methacrylate, 24 g (0.19 mol) of n-butyl acrylate and 189 g (0.81 mol) of γ-acryloxypropyltrimethoxysilane was fed to one dropping funnel, and a solution of 17 g of 2,2'-azobis(2-methylbutyronitrile) in 125 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80° C, cooling and filtration, yielding a solution P of a trimethoxysilyl group-containing (meth)acrylic copolymer with a weight average molecular weight of 9,500 and a silicon atom content of 5.7 wt%, having a solids concentration of 65%.

### Preparation Example 16

A 1-liter flask equipped with a stirrer, a condenser, a thermometer and a pair of dropping funnels was charged with 110 g of methyl isobutyl ketone and with stirring, heated at 80°C. A mixture of 98 g (0.98 mol) of methyl methacrylate, 189 g (1.48 mol) of n-butyl acrylate and 107 g (0.43 mol) of γ-methacryloxypropyltrimethoxysilane was fed to one dropping funnel, and a solution of 6 g of 2,2'-azobis(2-methylbutyronitrile) in 157 g of methyl ethyl ketone was fed to the other dropping funnel. With the internal temperature kept at 80°C, the solutions were added dropwise over 5 hours by a two-way dropwise addition process. This was followed by 2 hours of ripening reaction at 80°C, cooling and filtration, yielding a solution Q of a trimethoxysilyl group-containing (meth)acrylic copolymer with a weight average molecular weight of 26,000 and a silicon atom content of 3.0 wt%, having a solids concentration of 60%.

### Preparation Example 17

A room temperature curable, solventless silicone coating composition was prepared according to the method described in JP-A 7-173435. Specifically, 35 parts by weight of a dimethylpolysiloxane end-capped with hydroxyl groups having a viscosity of 700 mPa·s, 65 parts by weight of a dimethylpolysiloxane end-capped with hydroxyl groups having a viscosity of 30 mPa·s, 20 parts by weight of a dimethylpolysiloxane having a viscosity of 30 mPa·s, 20 parts by weight of vinyltriisopropenoxysilane, 1 part by weight of γ-aminopropyltriethoxysilane, and 1 part by weight of γ-tetramethylguanidylpropyltrimethoxysilane were mixed in dry conditions. The mixture was deaerated, yielding a silicone coating composition R having a viscosity of 60 mPa·s.

### Examples 1-11

To 100 parts by weight of each of the methoxysilyl group-containing (meth)acrylic copolymer solutions A to K obtained in Preparation Examples 1 to 11 was added 2 parts by weight of Chelope ACS (trade name by Hope Chemical Co., Ltd.), aluminum di-n-butoxy-ethylcetoacetate. They were agitated and mixed for one hour in a nitrogen atmosphere at room temperature, obtaining protective coating solutions. The composition and viscosity of these solutions are shown in Tables 1 and 2. The results of a silver plate sulfidation/corrosion test are shown in Tables 1 and 2 together with volume resistivity.

### Comparative Examples 1-6

As in Examples 1-11, protective coating solutions were prepared by adding 2 parts by weight of Chelope ACS, aluminum di-n-butoxy-ethylcetoacetate to 100 parts by weight of each of the methoxysilyl group-containing (meth)acrylic copolymer solutions L to Q obtained in Preparation Examples 12 to 16, agitating and mixing them for one hour in a nitrogen atmosphere at room temperature. The composition and viscosity of these solutions are shown in Table 3. The results of a silver plate sulfidation/corrosion test are shown in Table 3 together with volume resistivity. It is noted that in Comparative Example 6, the silicone coating composition R obtained in Preparation Example 17 was used as the protective coating solution, and similarly tested, with the results being shown in Table 3.

### Silver plate sulfidation/corrosion test

Surfaces of a silver test piece of 25 mm wide by 100 mm long by 0.3 mm thick (trade name SG-747-C by KDS Co., Ltd.) were degreased with toluene, and wiped with ethanol. The thus cleaned test piece was dipped in each of the coating solutions and pulled up. Each test piece was suspended, with the short sides up and down, dried for 20 minutes at room temperature, then for 10 minutes in a thermostat tank at 50° C, forming a coat. The coated test piece was then aged for 2 days in an atmosphere of 30° C/RH 70%. In a glass bottle on the bottom of which was placed 0.2 g of sulfur powder, the test piece with a coating film was suspended. The bottle was closed and held for 10 days in a thermostat tank at 80° C. The corrosion state on the silver surface was visually observed and rated according to the following criterion.
- ○:: no discoloration on silver surface, no corrosion with sulfur
- Δ:: partial discoloration or entire darkening, some corrosion with sulfur
- X:: entire blackening, noticeable corrosion with sulfur

### Volume resistivity

measured according to JIS K-6911 using a high-resistance meter.

Abbreviations used in Tables represent monomers of (meth)acrylic resins.
MMA: methyl methacrylate
BA: n-butyl acrylate
2-HEMA: 2-hydroxyethyl methacrylate
MPTS: γ-methacryloxypropyltrimethoxysilane
APDS: γ-acryloxypropylmethyldimethoxysilane
APTS: γ-acryloxypropyltrimethoxysilane

**Table 1**

| Example | | 1 | 2 | 3 | 4 | 5 |
|---|---|---|---|---|---|---|
| Copolymer solution | | A | B | C | D | E |
| Composition of coating solution (wt%) | Resin component | 78 | 69 | 64 | 59 | 69 |
| | Volatile solvent | 20 | 29 | 34 | 39 | 29 |
| | Catalyst | 2 | 2 | 2 | 2 | 2 |
| Mw | | 2,400 | 5,200 | 9,100 | 20,800 | 5,600 |
| Si atom content (wt%) | | 2.0 | 2.2 | 2.3 | 2.3 | 0.25 |
| Components of (meth)acrylic resin (mol%) | MMA | 81 | 81 | 81 | 81 | 89 |
| | BA | 9 | 9 | 9 | 9 | 10 |
| | 2-HEMA | - | - | - | - | - |
| | MPTS | 10 | 10 | 10 | 10 | 1 |
| | APDS | - | - | - | - | - |
| | APTS | - | - | - | - | - |
| Viscosity (mm²/s) | | 310 | 230 | 360 | 880 | 280 |
| Ag plate sulfidation/corrosion test | | ○ | ○ | ○ | ○ | ○ |
| Coat state after test | | No change | No change | No change | No change | No change |
| Volume resistivity (Ω·cm) | | 7×10¹⁴ | 7×10¹⁴ | 1×10¹⁵ | 6×10¹⁵ | 5×10¹⁵ |

**Table 2**

| Example | | 6 | 7 | 8 | 9 | 10 | 11 |
|---|---|---|---|---|---|---|---|
| Copolymer solution | | F | G | H | I | J | K |
| Composition of coating solution (wt%) | Resin component | 69 | 69 | 69 | 69 | 64 | 69 |
| | Volatile solvent | 29 | 29 | 29 | 29 | 34 | 29 |
| | Catalyst | 2 | 2 | 2 | 2 | 2 | 2 |
| Mw | | 5,000 | 5,200 | 4,900 | 5,000 | 9,300 | 5,100 |
| Si atom content (wt%) | | 1.2 | 1.9 | 3.8 | 2.3 | 2.2 | 2.2 |
| Components of (meth)acrylic resin (mol%) | MMA | 85 | 83 | 74 | 90 | 54 | 72 |
| | BA | 10 | 9 | 8 | - | 36 | 9 |
| | 2-HEMA | - | - | - | - | - | 9 |
| | MPTS | 5 | - | - | 10 | 10 | 10 |
| | APDS | - | 8 | 18 | - | - | - |
| | APTS | - | - | - | - | - | - |
| Viscosity (mm²/s) | | 220 | 180 | 150 | 300 | 320 | 170 |
| Ag plate sulfidation/corrosion test | | ○ | ○ | ○ | ○ | ○ | ○ |
| Coat state after test | | No change | No change | No change | No change | No change | No change |
| Volume resistivity (Ω·cm) | | 4×10¹⁵ | 1×10¹⁵ | 8×10¹⁴ | 2×10¹⁵ | 1×10¹⁵ | 2×10¹⁵ |

**Table 3**

| Comparative Example | | 1 | 2 | 3 | 4 | 5 | 6 |
|---|---|---|---|---|---|---|---|
| Copolymer solution | | L | M | N | P | Q | R* |
| Composition of coating solution (wt%) | Resin component | 69 | 49 | 59 | 64 | 59 | - |
| | Volatile solvent | 29 | 49 | 39 | 34 | 39 | - |
| | Catalyst | 2 | 2 | 2 | 2 | 2 | - |
| Mw | | 1,200 | 34,000 | 19,500 | 9,500 | 26,000 | - |
| Si atom content (wt%) | | 3.1 | 1.2 | 0.05 | 5.7 | 3.0 | - |
| Components of (meth)acrylic resin (mol%) | MMA | 80 | 76 | 90 | 63 | 34 | - |
| | BA | - | 19 | 9.8 | 7 | 51 | - |
| | 2-HEMA | - | - | - | - | - | - |
| | MPTS | 20 | 5 | 0.2 | - | 15 | - |
| | APDS | - | - | - | - | - | - |
| | APTS | - | - | - | 30 | - | - |
| Viscosity (mm²/s) | | 55 | 2,200 | 800 | 400 | 920 | 60 mPa·s |
| Ag plate sulfidation/corrosion test | | X | Δ | X | Δ | X | X |
| Coat state after test | | No change | Bulging at solution accumulated lower end | No change | Cracked | No change | No change |
| Volume resistivity (Ω·cm) | | 5×10¹³ | 6×10¹⁵ | 5×10¹⁵ | 3×10¹³ | 5×10¹⁴ | 5×10¹⁵ |

| | | | | | | | |
|---|---|---|---|---|---|---|---|
| * silicone coating composition obtained in Preparation Example 17 | | | | | | | |

As seen from Tables 1-3, the coating solutions of Examples 1 to 11 are satisfactory in all of applicability, silver corrosion prevention, coat state and volume resistivity. Corrosion over the entire surface of silver piece was observed in Comparative Examples 1, 3, 5 and 6. In Comparative Example 2, the solution was difficult to apply and bulging occurred at the lower end of the test piece where the solution accumulated thickly, and the silver surface in this area was corroded. In Comparative Example 4, cracks extended from the end and corrosion was observed along the cracks.

There has been described a coating composition which can be easily and reliably applied to substrates having metal portions on their surface, and which after coating, can cure with air-borne moisture to form a uniform coat that maintains good electrically insulating properties and prevents the underlying metal portions from corrosion with sulfur compounds (i.e., sulfidation). The inventive method is effective for protecting packaging and interconnecting boards from a harsh external environment and sulfur compounds. Also a thus protected packaging and interconnecting board is contemplated herein.

Although some preferred embodiments have been described, many modifications and variations may be made thereto in light of the above teachings. It is therefore to be understood that the invention may be practiced otherwise than as specifically described in relation to embodiments herein.

## Claims

1. A method of making a packaging and interconnecting board having electrical and electronic parts mounted thereon, and coated to protect metal portions on the board, comprising:
applying a coating composition to the board;
drying the applied composition to form a coat, and
exposing the coat to air-borne moisture for curing the coat;
**characterised in that** the coating composition primarily comprises (meth)acrylic resin which contains hydrolysable silyl and/or silanol groups, has a silicon atom content of from 0.1 to 5% by weight and a weight average molecular weight of from 1,500 to 30,000, and in which at least 50 mol% of monomer residues are of methyl methacrylate.

2. A method according to claim 1 in which the metal portions comprise silver.

3. A method according to claim 1 or 2 in which the coating composition comprises from 1 to 50% by weight of volatile solvent.

4. A method according to claim 3 in which the volatile solvent is selected from toluene, acetone, methyl ethyl ketone, methyl isobutyl ketone and ethyl acetate.

5. A method according to any one of claims 1 to 4 in which the coating composition comprises from 0.01 to 10% by weight of organometallic condensation catalyst.

6. A method according to any one of claims 1 to 5 wherein said (meth)acrylic resin has a weight average molecular weight of from 2,000 to 10,000.

7. A method according to any one of claims 1 to 6 wherein said (meth)acrylic resin has a silicon atom content of from 0.2 to 3% by weight.

8. A method according to any one of claims 1 to 7 wherein said (meth)acrylic resin is a copolymer consisting essentially of residues of from 0.5 to 20 mol% of unsaturated silane compound containing polymerisable double bond and hydrolysable silyl group, from 50 to 99.5 mol% of methyl methacrylate and from 0 to 40 mol% of butyl acrylate.

9. A method according to any one of claims 1 to 8 in which said hydrolysable groups of the (meth)acrylic resin are of the formula
-SiXₐR¹ ₃₋ₐ
where a is from 1 to 3, X is or are selected from hydroxyl, halogen, alkoxy, acyloxy, oxime, amide, alkenoxy and amino groups, and R¹ is or are selected from hydrogen and monovalent C₁₋₁₀ hydrocarbon groups.

10. A method according to any one of claims 1 to 9 in which the coating composition has a viscosity of not more than 1000 mm²/s at 25°C.

11. A method according to claim 10 in which the coating composition has a viscosity of from 40 to 500 mm²/s at 25°C.

12. A method according to any one of claims 1 to 11 in which the coating composition is applied by dip coating, flow coating, brush coating or spray coating.

13. A method according to any one of the preceding claims in which the steps of drying and curing are at room temperature or at elevated temperature in the range 30 to 100°C.

14. A method according to claim 2 or any claim dependent thereon in which said board is a circuit board having silver wiring.

15. A packaging and interconnecting board having electric and electronic parts mounted thereon, on which a cured coat is provided to protect metal portions on the board, made by a method according to any one of claims 1 to 14.

## Patentansprüche

1. Verfahren zur Herstellung von Platinen und Leiterplatten, auf denen elektrische und elektronische Bauteile montiert sind und die beschichtet sind, um Metallteile auf der Platte zu schützen, umfassend:
Auftragen einer Beschichtungszusammensetzung auf die Platte;
Trocknen der aufgetragenen Zusammensetzung, um eine Beschichtung zu bilden, und
Aussetzen der Beschichtung gegenüber Luftfeuchtigkeit, um die Beschichtung zu härten;
**dadurch gekennzeichnet, dass** die Beschichtungszusammensetzung hauptsächlich (Meth)acrylharz umfasst, das hydrolysierbare Silyl- und/oder Silanolgruppen enthält, einen Siliciumatomgehalt von 0,1 bis 5 Gew.-% und ein gewichtsmittleres Molekulargewicht von 1.500 bis 30.000 aufweist und worin zumindest 50 Mol-% der Monomerreste von Methylmethacrylat stammen.

2. Verfahren nach Anspruch 1, worin die Metallteile Silber umfassen.

3. Verfahren nach Anspruch 1 oder 2, worin die Beschichtungszusammensetzung 1 bis 50 Gew.-% eines flüchtigen Lösungsmittels umfasst.

4. Verfahren nach Anspruch 3, worin das flüchtige Lösungsmittel aus Toluol, Aceton, Methylethylketon, Methylisobutylketon und Ethylacetat ausgewählt ist.

5. Verfahren nach einem der Ansprüche 1 bis 4, worin die Beschichtungszusammensetzung 0,01 bis 10 Gew.-% eines organometallischen Kondensationskatalysators umfasst.

6. Verfahren nach einem der Ansprüche 1 bis 5, worin das (Meth)acrylharz ein gewichtsmittleres Molekulargewicht von 2.000 bis 10.000 aufweist.

7. Verfahren nach einem der Ansprüche 1 bis 6, worin das (Meth)acrylharz einen Siliciumatomgehalt von 0,2 bis 3 Gew.-% aufweist.

8. Verfahren nach einem der Ansprüche 1 bis 7, worin das (Meth)acrylharz ein Copolymer ist, das im Wesentlichen aus Resten aus 0,5 bis 20 Mol-% einer ungesättigten Silanverbindung, die eine polymerisierbare Doppelbindung und eine hydrolysierbare Silylgruppe enthält, 50 bis 99,5 Mol-% Methylmethacrylat und 0 bis 40 Mol-% Butylacrylat besteht.

9. Verfahren nach einem der Ansprüche 1 bis 8, worin die hydrolysierbaren Gruppen des (Meth)acrylharzes die Formel
-SiXₐR¹ ₃₋ₐ
aufweisen, worin a = 1 bis 3 ist, X aus Hydroxyl-, Halogen, Alkoxy-, Acyloxy-, Oxim-, Amid-, Alkenoxy- und Aminogruppen ausgewählt ist oder sind und R¹ aus Wasserstoff und einwertigen C₁₋₁₀-Kohlenwasserstoffgruppen ausgewählt ist oder sind.

10. Verfahren nach einem der Ansprüche 1 bis 9, worin die Beschichtungszusammensetzung eine Viskosität von nicht mehr als 1.000 mm²/s bei 25 °C aufweist.

11. Verfahren nach Anspruch 10, worin die Beschichtungszusammensetzung eine Viskosität von 40 bis 500 mm²/s bei 25 °C aufweist.

12. Verfahren nach einem der Ansprüche 1 bis 11, worin die Beschichtungszusammensetzung durch Tauchbeschichten, Flutbeschichten, Anstreichen oder Sprühbeschichten aufgetragen wird.

13. Verfahren nach einem der vorangegangenen Ansprüche, worin die Schritte des Trocknens und Härtens bei Raumtemperatur oder erhöhter Temperatur im Bereich von 30 bis 100 °C durchgeführt werden.

14. Verfahren nach Anspruch 2 oder einem davon abhängenden Anspruch, worin die Platte eine Leiterplatte mit Silberverdrahtung ist.

15. Platine und Leiterplatte, auf der elektrische und elektronische Bauteile montiert sind, auf der durch ein Verfahren nach einem der Ansprüche 1 bis 14 eine gehärtete Beschichtung bereitgestellt wird, um Metallteile auf der Platte zu schützen.

## Revendications

1. Méthode de production d'une planche de substrat et d'interconnexion ayant des pièces électriques et électroniques qui y sont montées et revêtue pour protéger les portions métalliques sur la planche, comprenant
l'application d'une composition d'un revêtement à la planche;
le séchage de la composition appliquée pour former un revêtement et
l'exposition de revêtement à l'humidité de l'air pour durcir le revêtement
**caractérisée en ce que** la composition du revêtement comprend principalement une résine (méth)acrylique qui contient des groupes silyles et/ou silanols hydrolysables, a une teneur en atomes de silicium de 0,1% à 5% en poids et un poids moléculaire moyen en poids de 1 500 à 30 000 et où au moins 50% en moles des résidus monomères sont du méthacrylate de méthyle.

2. Méthode selon la revendication 1 dans laquelle les portions de métal comprennent de l'argent.

3. Méthode selon la revendication 1 ou 2 dans laquelle la composition de revêtement comprend de 1 à 50% en poids d'un solvant volatil.

4. Méthode selon la revendication 3 dans laquelle le solvant volatil est sélectionné parmi toluène, acétone, méthyl éthyl cétone, méthyl isobutyl cétone et acétate d'éthyle.

5. Méthode selon l'une quelconque des revendications 1 à 4, dans laquelle la composition de revêtement comprend 0,01 à 10% en poids d'un catalyseur de condensation organométallique.

6. Méthode selon l'une quelconque des revendications 1 à 5, où ladite résine (méth)acrylique a un poids moléculaire moyen en poids de 2 000 à 10 000.

7. Méthode selon l'une quelconque des revendications 1 à 6, où ladite résine (méth)acrylique a une teneur en atomes de silicium de 0,2 à 3% en poids.

8. Méthode selon l'une quelconque des revendications 1 à 7, où ladite résine (méth)acrylique est un copolymère consistant essentiellement en résidus de 0,5 à 20% en moles d'un composé de silane insaturé contenant une double liaison polymérisable et un groupe silyle hydrolysable, de 50 à 99,5% en moles de méthacrylate de méthyle et de 0 à 40% en moles d'acrylate de butyle.

9. Méthode selon l'une quelconque des revendications 1 à 8 dans laquelle lesdits groupes hydrolysables de la résine (méth)acrylique sont de la formule
-SiXₐR¹ ₃₋ₐ
où a est de 1 à 3, X est ou sont sélectionnés parmi des groupes hydroxyle, halogène, alcoxy, acyloxy, oxime, amide, alcénoxy et amino, et R¹ est ou sont sélectionnés parmi hydrogène et groupes hydrocarbures monovalents C₁₋₁₀.

10. Méthode selon l'une quelconque des revendications 1 à 9 dans laquelle la composition du revêtement a une viscosité de pas plus de 1 000 mm²/s à 25°C.

11. Méthode selon la revendication 10 dans laquelle la composition du revêtement a une viscosité de 40 à 500 mm²/s à 25°C.

12. Méthode selon l'une quelconque des revendications 1 à 11 dans laquelle la composition du revêtement est appliquée par revêtement par immersion, revêtement par écoulement, revêtement au pinceau ou revêtement au jet.

13. Méthode selon l'une quelconque des revendications précédentes dans laquelle les étapes de séchage et durcissement sont à température ambiante ou à température élevée dans la gamme de 30 à 100°C.

14. Méthode selon la revendication 2 ou toute revendication qui en dépend dans laquelle ladite planche est une planche de circuit ayant un câblage d'argent.

15. Planche de substrat et d'interconnexion ayant des pièces électriques et électroniques qui y sont montées, sur laquelle un revêtement durci est prévu pour protéger les portions de métal sur la planche, fait par une méthode selon l'une quelconque des revendications 1 à 14.
